# FASCICULE DE BREVET EUROPEEN

(11) **EP 0 731 975 B1**
(45) Date de publication et mention de la délivrance du brevet: **20.01.1999**
(21) Numéro de dépôt: 95902823.4
(22) Date de dépôt: 01.12.1994
(51) Int. Cl.: H01G 4/30, H01G 4/008, H01G 4/012, C23C 16/34

(54) **COMPOSANT DE TYPE EMPILE ET PROCEDE DE FABRICATION DE COMPOSANT DE TYPE EMPILE**
STAPELBAUELEMENT UND HERSTELLUNGSVERFAHREN FÜR EIN STAPELBAUELEMENT
STACKED-TYPE COMPONENT AND METHOD FOR THE MANUFACTURE OF SAME

(30) Priorité: 03.12.1993 FR 9314520
(43) Date de publication de la demande: 18.09.1996
(73) Titulaire: COMPAGNIE EUROPEENNE DE COMPOSANTS ELECTRONIQUES LCC, F-21860 St. Apollinaire (FR)
(72) Inventeur: STEPHAN, Ronan, F-92402 Courbevoie Cédex (FR); CALLEBERT, Frank, F-92402 Courbevoie Cédex (FR)
(74) Mandataire: Guérin, Michel
(86) Numéro de dépôt international: FR9401405
(87) Numéro de publication internationale: WO9515571

(56) Documents cités:
- US-A- 4 599 678
- SURFACE AND COATINGS TECHNOLOGY, vol.59, no.1-3, 1993, SUISSE pages 193 - 201 KULISCH W. 'Remote-Plasma-Enhanced Chemical Vapour Deposition with Metal-Organic Source Gases. Princeiples and Applications'

## Description

La présente invention concerne des composants capacitifs et/ou résistifs de type empilé ainsi qu'un procédé de fabrication de composant de type empilé.

L'invention sera plus particulièrement décrite pour la fabrication de condensateurs de type empilé. Cependant, comme cela sera précisé ultérieurement, l'invention conceme aussi la fabrication de résistances.

La fabrication de condensateurs de type empilé peut s'effectuer de différentes manières. L'une d'entre elles consiste à utiliser des films plastiques souples métallisés.

Généralement les films plastiques souples présentent alors une zone métallisée et une marge latérale non métallisée et sont issus de la découpe d'un laize de film plastique souple métallisé de grande largeur.

Une des étapes du procédé de fabrication consiste à enrouler au moins une paire de films plastiques souples métallisés sur une roue de grand diamètre. L'enroulement est effectué de façon que les marges non métallisées de deux films qui se superposent se retrouvent sur des côtés opposés.

On obtient alors un ruban capacitif d'épaisseur voulue suivant le nombre de tours effectués. On recouvre ensuite avec un métal ou un alliage de métaux chacun des flancs du ruban capacitif.

C'est l'opération de shoopage destiné à créer les armatures de sortie des futurs condensateurs. Le ruban capacitif ainsi obtenu est appelé condensateur-mère. On procède alors à la découpe du condensateur-mère en blocs unitaires appelés condensateurs semi-finis.

Une autre manière de réaliser des condensateurs de type empilé consiste à assembler des feuilles diélectriques métallisées. L'assemblage des feuilles diélectriques métallisées s'effectue par frittage après avoir empilé à plat les feuilles les unes sur les autres.

Il est ensuite nécessaire de découper les assemblages ainsi constitués et de réaliser les armatures des condensateurs élémentaires.

Il est aussi connu selon le document US,A, 4 599 678 de réaliser des condensateurs sur substrat de verre constitués de deux électrodes métalliques encadrant une couche diélectrique formée dans un plasma de décharge.

L'inconvénient de tels procédés consiste, d'une part, en leur grand nombre d'étapes et, d'autre part, en ce que les composants obtenus présentent des capacités volumiques relativement limitées du fait de la nature et de l'épaisseur des diélectriques utilisés.

A titre d'exemple, les diélectriques utilisés pour réaliser les films plastiques entrant dans la composition des condensateurs à films plastiques souples métallisés sont le polyester, le polycarbonate, le polysulfure de phénylène ou encore le polypropylène. La capacité volumique obtenue n'excède alors pas 10 nano Farads par millimètre cube.

L'invention ne présente pas ces inconvénients.

Le procédé de l'invention est défini par les caractéristiques de la revendication 1. Le condensateur et la résistance de l'invention sont définis par les caractéristiques des revendications 36 et 37, respectivement.

La présente invention concerne une structure nouvelle de condensateur de forte capacité volumique. Comme cela apparaîtra ultérieurement il est possible de constituer de manière inattendue des résistances de type empilé en modifiant cette structure nouvelle.

On propose donc, selon l'invention, un condensateur de type empilé constitué d'une alternance de couches diélectriques de rang impair et pair et de couches conductrices de rang impair et pair, ledit condensateur empilé constituant une structure ayant deux faces latérales opposées recouvertes de matériau conducteur, caractérisé en ce que les couches diélectriques sont obtenues par dépôts d'éléments diélectriques en couche mince et les couches conductrices par dépôts d'éléments conducteurs en couche mince, le recouvrement de matériau conducteur d'une première face latérale étant obtenue par lesdits dépôts d'éléments conducteurs de façon à relier électriquement entre elles les couches conductrices de rang pair et le recouvrement de matériau conducteur de la face latérale opposée à ladite première face étant obtenue par lesdits dépôts d'éléments conducteurs de façon à relier électriquement entre elles les couches conductrices de rang impair.

On propose, également selon l'invention, une résistance caractérisée en ce qu'elle est constituée de l'empilement successif de couches minces diélectriques et de couches minces conductrices, les couches minces conductrices constituant des éléments résistifs élémentaires superposés mis en série les uns avec les autres lors de l'empilement.

De manière plus précise, la résistance selon l'invention est caractérisée en ce qu'elle est constituée d'une alternance de couches diélectriques de rang impair et pair et de couches conductrices de rang impair et pair, ladite alternance constituant une structure ayant deux faces latérales opposées recouvertes de matériau conducteur, les couches diélectriques étant obtenues par dépôts d'éléments diélectriques en couche mince et les couches conductrices par dépôts d'éléments conducteurs en couche mince, chaque couche conductrice ayant une première extrémité située sur une première face latérale et une deuxième extrémité située sur une deuxième face latérale opposée à la première face latérale, une couche conductrice de rang impair ayant sa première extrémité électriquement reliée à la première extrémité de la couche conductrice de rang pair immédiatement au-dessus et une couche conductrice de rang pair ayant sa deuxième extrémité électriquement reliée à la deuxième extrémité de la couche conductrice de rang impair immédiatement au-dessus, les liaisons électriques entre lesdites extrémités étant réalisées lors du dépôt des couches conductrices.

L'invention concerne également l'association en série ou en parallèle d'au moins une résistance et d'au moins un condensateur tels celles et ceux mentionnés ci-dessus.

L'invention concerne également un procédé de fabrication d'un composant capacitif ou résistif, de type empilé, constitué d'un empilement de plusieurs couches diélectriques alternées avec plusieurs couches conductrices, les couches conductrices comportant successivement des couches de rang impair alternées avec des couches de rang pair, caractérisé en ce que les couches diélectriques et les couches conductrices sont réalisées respectivement par dépôt de matériau diélectrique en couche mince et par dépôt de matériau conducteur en couche mince.

Un avantage important de ce procédé de fabrication, dans le cas d'un condensateur, est de permettre, lors du dépôt des éléments conducteurs, de recouvrir de matériau conducteur les deux faces latérales opposées destinées à devenir les armatures du condensateur.

Un avantage important de ce procédé de fabrication, dans le cas d'une résistance, est de permettre la mise en série des couches conductrices les unes avec les autres lors du dépôt des éléments conducteurs.

Selon le mode de réalisation préférentiel de l'invention, les dépôts de couches minces diélectriques et conductrices sont réalisés en présence de plasma différé, d'azote : les couches diélectriques sont alors déposées par polymérisation d'éléments issus de la dissociation par plasma différé d'azote d'un gaz organo-silicé ou organo-germané et les couches conductrices sont réalisées par dépôt d'éléments conducteurs issus de la dissociation par plasma différé d'azote d'un gaz précurseur de ces éléments conducteurs. Le gaz précurseur des éléments conducteurs peut être un complexe métallique ou encore de l'hydrogène sulfureux ou du dichlorure de soufre.

Selon un aspect important de l'invention, le procédé de dépôt des couches minces alternativement diélectriques et conductrices est effectué dans un réacteur qui comprend au moins deux cavités de dépôt : l'une est réservée au dépôt de couches diélectriques et l'autre au dépôt de couches conductrices, les opérations de dépôt étant effectuées simultanément sur un même substrat défilant cycliquement dans les deux cavités.

D'autres caractéristiques et avantages de l'invention apparaîtront à la lecture d'un mode de réalisation préférentiel fait avec référence aux figures ci-annexées dans lesquelles :
- la figure 1 est une représentation de principe d'un plasma de décharge en écoulement tel que mis en oeuvre selon une modification préférée de l'invention ;
- la figure 2 est un schéma de principe du dispositif utilisé dans le procédé selon l'invention ;
- la figure 3 est une vue de détail du schéma de principe de la figure 2 ;
- la figure 4 est une vue en coupe d'une structure capacitive obtenue selon l'invention ;
- la figure 5 est une vue en coupe d'une structure résistive obtenue selon l'invention ;
- la figure 6 est une vue en coupe d'une structure résistive et capacitive obtenue selon l'invention ;
- la figure 7 est une vue en coupe d'un dispositif de masquage utilisé dans une modification du procédé selon l'invention.

Sur toutes les figures les mêmes repères désignent les mêmes éléments.

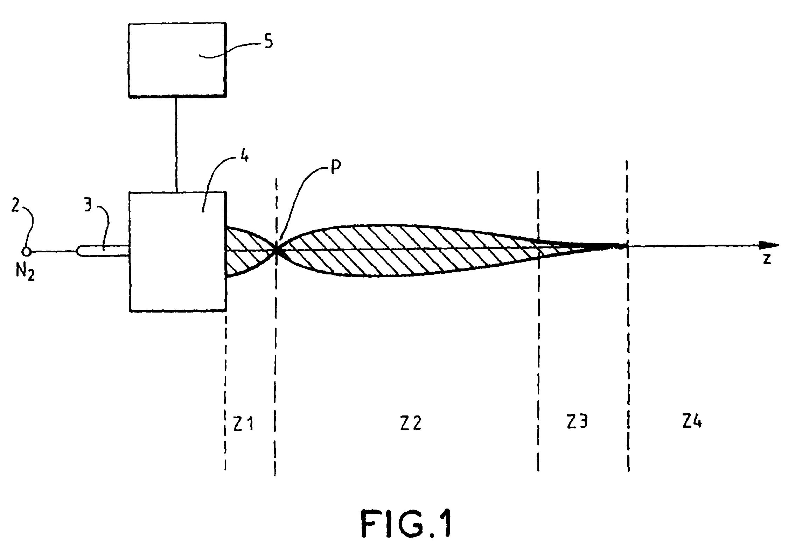

La figure 1 est une représentation de principe d'un plasma de décharge en écoulement tel que mis en oeuvre dans une modification du procédé selon l'invention.

Une source 2 d'alimentation d'azote est envoyée par l'intermédiaire d'un tube 3 dans une cavité micro-onde 4.

La pression de l'azote à l'intérieur du tube 3 est comprise entre 1 et 20 hPa. Sous l'effet de l'onde générée par le générateur micro-onde , une décharge est entretenue dans la cavité 4. La fréquence de l'onde issue du générateur micro-onde 5 est, par exemple, égale à 2450 MHz, à 433 MHz, ou à 915 MHz. L'écoulement effectué par une pompe à vide (non représentée sur la figure 1) est établi selon l'axe des z. Les zones hachurées représentent de manière symbolique la distribution en ions et en électrons présents dans les zones d'évacuation du plasma de décharge situées entre la sortie de la cavité de décharge et la pompe à vide.

La zone Z1 est une première zone de post-décharge dans laquelle la concentration en ions et en électrons diminue continuellement entre la sortie de la cavité de décharge et une zone d'extinction de très faible extension, représentée par le point P.

La zone Z2, qui succède à la zone Z1, est une deuxième zone de post-décharge ionique dans laquelle la concentration en ions et électrons n'est pas négligeable. Elle est d'extension plus grande que la zone Z1.

La zone Z3, qui succède la zone Z2, est une zone intermédiaire entre la zone Z2 et la zone Z4 laquelle est quasiment dépourvue d'électrons et d'ions. La concentration en ions et en électrons diminue continûment entre la deuxième partie de la zone Z2 et la zone Z4.

La zone Z4 est une zone de post-décharge susceptible de prendre une large extension dans l'espace.

Dans la zone Z4, la durée de vie effective des vecteurs d'énergie, notamment de l'azote vibrationnnellement excité est avantageusement longue. Il a été mesuré des durée de vie de l'ordre de 10 secondes. Avantageusement c'est donc le plasma différé en écoulement situé dans cette zone de post-décharge étendue qui est utilisé selon l'invention. A titre d'exemple, il a été mesuré que la distance séparant la sortie de la cavité 4 du début de la zone Z4 peut être supérieure ou égale à 1 mètre.

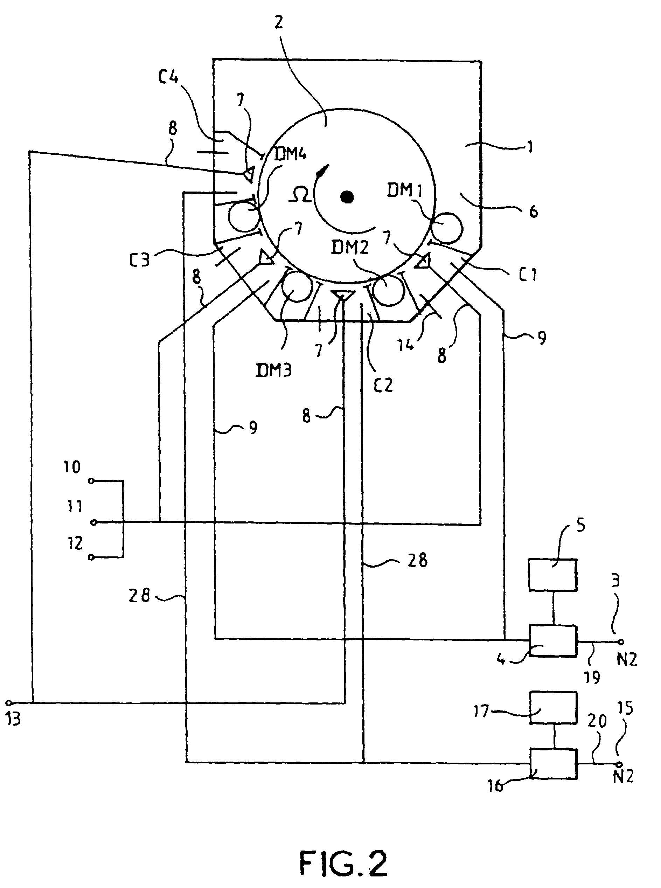

La figure 2 est un schéma de principe du dispositif selon l'invention.

Un substrat diélectrique 1 est déposé sur un tambour 2 qui tourne à la vitesse angulaire Ω. Ce substrat, dont la fonction est de servir de support, peut être réalisé en tout matériau dont les caractéristiques électriques ne perturbent pas les caractéristiques électriques des composants issus du procédé.

Selon l'art antérieur, les dépôts assistés par plasma de décharge sont effectués sur des substrats chauffés. Un autre avantage du dépôt par plasma froid différé en écoulement est de ne pas devoir chauffer le substrat sur lequel sont effectués les dépôts. Les caractéristiques mécaniques du substrat ne sont donc pas dégradées et la fiabilité des composants issus du procédé de l'invention se trouve améliorée par rapport à celle des composants issus des procédés de l'art antérieur.

Selon le mode de réalisation préférentiel de l'invention, une même portion du matériau diélectrique 1 se trouve successivement en regard d'un premier dispositif de masquage DM1, d'une première cavité C1 où s'effectue le premier dépôt de diélectrique, d'un deuxième dispositif de masquage DM2, d'une deuxième cavité C2 où s'effectue le premier dépôt de polymère conducteur, d'un troisième dispositif de masquage DM3, d'une troisième cavité C3 où s'effectue le deuxième dépôt de diélectrique, d'un quatrième dispositif de masquage DM4, et d'une quatrième cavité C4 où s'effectue le deuxième dépôt de polymère conducteur.

Le tambour 2, les cavités C1, C2, C3 et C4 de même que les dispositifs de masquages sont situés à l'intérieur d'un même réacteur 6.

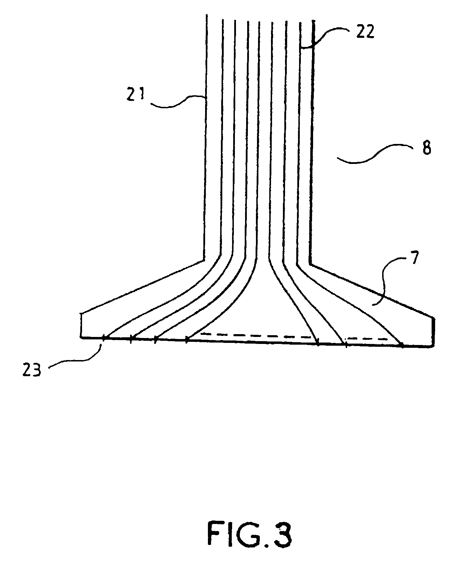

Les masques déposés par les dispositifs de masquage DM1, DM2, DM3, et DM4 seront décrits ultérieurement de même que les dispositifs de masquage eux-mêmes (cf. figures 3, 4 et 5).

Selon le mode de réalisation préférentiel de l'invention, les couches diélectriques déposées dans les cavités C1 et C3 sont obtenues par polymérisation d'éléments issus de la dissociation par plasma différé d'azote d'un gaz précurseur du dépôt tel qu'un gaz organo-silicé ou organo-germané.

Le plasma différé utilisé est un plasma froid différé en écoulement. Le plasma froid différé en écoulement est obtenu sous une pression de quelques hPa, par extraction et détente dans un réacteur, en dehors du champ électrique, des espèces actives formées dans un plasma en décharge.

Comme cela a été décrit précédemment, le plasma froid différé en écoulement selon l'invention ne contient pratiquement pas d'électrons ou d'ions. Les espèces réactives sont essentiellement des atomes, des radicaux libres et des espèces moléculaires électriquement et vibrationnellement excitées. Un tel plasma froid différé ne peut être obtenu que dans des régions relativement éloignées de la cavité 4. Il s'en suit que la distance qui sépare la sortie de la cavité 4 de la surface 1 où ont lieu les dépôts doit être choisie en conséquence. A titre d'exemple, cette distance peut être supérieure ou égale à 1 mètre.

Dans le cas présent, une source 3 d'alimentation d'azote est envoyée dans une cavité micro-onde 4, par l'intermédiaire d'un tube 19. La pression de l'azote à l'intérieur du tube 19 est comprise entre 1 et 20 hPa. Sous l'effet de l'onde générée par le générateur micro-onde 5, une décharge est entretenue dans la cavité 4. La fréquence de l'onde issue du générateur micro-onde 5 est, par exemple, égale à 2450 Mhz, à 433 Mhz, ou à 915 MHz. L'azote, excité en sortie de la cavité micro-onde 4, est amené par l'intermédiaire de tubes 9 à l'intérieur des cavités C1 et C3 où doivent s'effectuer les dépôts de diélectrique. Le pourcentage d'azote dissocié est, à titre d'exemple, compris entre 0,5 et 3 pour cent.

Le gaz organo-silicé ou organo-germané issu de la source 10 est introduit dans les cavités C1 et C3 par l'intermédiaire d'un dispositif 8 dont le schéma sera détaillé en figure 3. L'extrémité évasée 7 du dispositif 8 permet au gaz de se répartir au-dessus de la surface sur laquelle le dépôt de diélectrique doit s'effectuer.

L'azote excité se trouve donc mélangé au gaz précurseur du dépôt dans la zone située entre l'extrémité évasée 7 du dispositif 8 et la surface où la polymérisation s'effectue. Cette extrémité évasée est située dans la zone de post-décharge étendue non ionique du plasma d'azote en écoulement. L'écoulement est réalisé à l'aide d'une pompe à vide 14. Pour des raisons de commodité la pompe à vide 14 a été représentée symboliquement sur la figure 2. De façon préférentielle elle est disposée selon une génératrice du tambour 2 et se divise de part et d'autre de l'extrémité évasée 7. Comme cela a été mentionné précédemment, le gaz précurseur du dépôt peut être un composé organo-germané. Ce peut aussi être un composé organo-silicé choisi parmi les alkoxysilanes, les siloxanes ou les silazanes. Selon le mode de réalisation préférentiel de l'invention, il s'agit de tetramethyldisiloxane.

L'utilisation d'un plasma différé en zone de post-décharge étendue est un avantage de l'invention. En effet, en opposition avec les plasmas de décharge ou de post-décharge usuels les plasmas différés en zone de post-décharge étendue sont des milieux actifs dépourvus d'électrons et exempts de radiations énergétiques sur une grande extension spatiale. L'absence de champ électrique favorise le dépôt des éléments lourds sur les couches conductrices et améliore la vitesse de dépôt. D'autre part, comme cela a déjà été mentionné précédemment, la durée de vie effectives des vecteurs d'énergie y est avantageusement longue.

Selon le mode de réalisation préférentiel de l'invention, les dispositifs 8 d'injection du composé gazeux organo-silicé sont reliés à une même source d'oxygène 11. L'introduction d'oxygène dans les cavités C1 et C3 en même temps que le composé organo-silicé accélère avantageusement la vitesse de formation de la couche de diélectrique sur la couche conductrice. Un autre avantage de la présence d'oxygène est la formation de groupements polaires, tels que les groupements OH, dans les couches diélectriques déposées. Il s'en suit une amélioration de la constante diélectrique du matériau. La teneur en oxygène est de l'ordre de quelques pour cent du mélange gazeux présent dans les cavités C1 et C3. Elle peut atteindre des valeurs de 10 à 15 % pour des chambres de dépôt de grandes dimensions.

Un autre agent dopant 12 peut être introduit dans le réacteur par les dispositifs 8 d'injection. Il peut s'agir, par exemple, d'un gaz de la famille des tétrakysdialkylamidotitanium IV. Ce deuxième agent dopant permet alors d'accroître l'action du premier agent dopant en ce qui concerne la formation de groupements polaires. Dans ce cas les groupements polaires sont à base d'oxyde de titane.

Un avantage de l'invention est le dépôt d'une couche de diélectrique possédant d'excellentes qualités d'adhérence et d'homogénéité et dont l'épaisseur obtenue peut varier, selon les besoins, de 0,05 micron à quelques microns.

Les composés organo-silicés introduits dans le réacteur peuvent être :
un alkoxysilane de formule 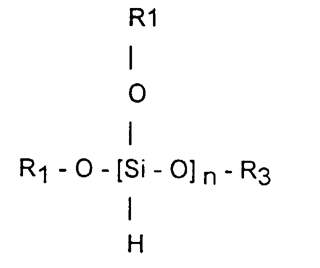 avec n inférieur ou égal à 5
un siloxane de formule 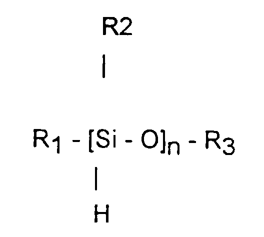 avec n inférieur ou égal à 4
un silazane de formule 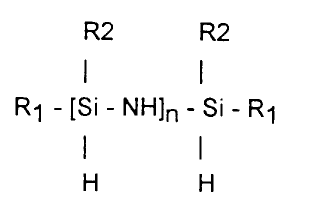 avec n inférieur à 4

La constante diélectrique relative des dépôts obtenus peut atteindre des valeurs supérieures à 30. Selon une modification du procédé de l'invention, la source d'oxygène 11 ou l'élément dopant du gaz précurseur 12 peuvent contenir de l'oxyde de titane, par exemple de l'isopropylate de titane (IV), afin d'augmenter encore la valeur de la constante diélectrique relative du dépôt. A priori, il est connu de l'homme de l'art que les diélectriques ayant des constantes diélectriques relatives élevées présentent souvent des pertes élevées, ainsi qu'une mauvaise tenue en température.

Dans le cas présent, il a été constaté que le dépôt diélectrique selon l'invention ne présentait pas ces inconvénients.

La tenue en température se trouve améliorée, la température maximale d'utilisation pouvant atteindre de l'ordre de 300° C.

Les tensions de claquage des diélectriques se trouvent, elles aussi, fortement améliorées pouvant atteindre, par exemple, 2 000 Volts par micro.

De façon générale, le procédé selon l'invention concerne différents gaz précurseurs du dépôt (composé organo-germané, alkosysilane, siloxane, silazane).

Ainsi, le procédé selon l'invention permet-il avantageusement la polymérisation de différents diélectriques sur les couches conductrices.

A titre d'exemple, lorsqu'on introduit dans les cavités C1 et C3 un silazane, on obtient une couche diélectrique formée des composés suivants :

- Si - NH - Si

- Si - O - Si

- Si - C - Si

Lorsqu'on introduit un siloxane, on obtient une couche diélectrique formée des composés suivants :
polymère (Si - O - Si) réticulé

- Si - (CH₃) 1

- Si - OH

- Si - NH - Si

pour une très faible teneur en oxygène.
ou bien :
polymère (Si - O - Si) réticulé

- Si - (CH₃)₂

- Si - (CH₃)₂

- Si - OH

- SI - NH -Si

pour une teneur en oxygène plus élevée.

Selon le mode de réalisation préférentiel de l'invention, le gaz dopant est de l'oxygène. Selon d'autres modes de réalisation, il peut s'agir, plus généralement, d'un composé gazeux contenant de l'oxygène.

Comme cela a été mentionné précédemment, une même portion de matériau est soumise à un dépôt d'éléments conducteurs après avoir été soumise à un dépôt de diélectrique. Ce dépôt d'éléments conducteurs s'effectue dans les cavités C2 et C4.

Selon un premier mode de réalisation de l'invention, les éléments conducteurs sont des polymères conducteurs déposés par polymérisation d'éléments issus de la dissociation par plasma différé d'azote d'un gaz précurseur du dépôt tel que l'hydrogène sulfureux ou le dichlorure de soufre. Par recombinaison radicalaire du radical SN, les polymères conducteurs sont des polynitrures de soufre de formule chimique S₄N₄ ou (SN)ₓ, x étant un nombre entier supérieur à 4.

Selon un autre mode de réalisation de l'invention, les éléments conducteurs déposés sont issus de la dissociation par plasma différé d'azote d'un complexe métallique.

Ce complexe métallique peut être un métal carbonyle tel que, par exemple, le fer carbonyle ou le nickel carbonyle, ou encore un acétyle acétonate ou un fluro-acétyle acétonate.

Le plasma différé est un plasma froid différé en écoulement, à l'image de celui réalisé pour le dépôt du diélectrique.

Une source 15 d'alimentation d'azote est envoyée dans une cavité 16 par l'intermédiaire d'un tube 20. La pression de l'azote à l'intérieur du tube 20 est comprise entre 1 et 20 hPa. Sous l'effet de l'onde générée par le générateur micro-onde 17, une décharge est entretenue dans la cavité 16. La fréquence de l'onde issue du générateur micro-onde 17 est, par exemple, égale à 2450 MHz, à 433 MHz, ou à 915 MHz. L'azote, excité en sortie de la cavité micro-onde 16, est amené par l'intermédiaire de tubes 28 à l'intérieur des cavités C2 et C4 où doivent s'effectuer les dépôts de polymères conducteurs. Préférentiellement, la quantité de soufre est légèrement en excès par rapport à la quantité d'azote de façon que le polymère conducteur présente de meilleures performances de conductivité.

L'hydrogène sulfureux ou le dichlorure de soufre issu de la source 13 est introduit dans les cavités C2 et C4 par l'intermédiaire d'un dispositif 8 dont le schéma sera détaillé en figure 2. L'extrémité évasée 7 du dispositif 8 permet au gaz de se répartir au-dessus de la surface où le dépôt de polymère conducteur doit s'effectuer.

L'azote excité se trouve donc mélangé au gaz précurseur du dépôt dans la zone située entre l'extrémité évasée 7 du dispositif 8 et la surface où doit s'effectuer la polymérisation. Cette extrémité évasée est située dans la zone de post-décharge étendue non ionique du plasma d'azote en écoulement. L'écoulement est réalisé à l'aide d'une pompe à vide 14.

Avantageusement, le procédé selon l'invention permet de réaliser des couches de polymère conducteur ayant des épaisseurs faibles. Celles-ci peuvent, en effet, être de l'ordre de 0,05 µm.

Selon le mode de réalisation préférentiel décrit en figure 2, à chaque révolution du tambour 2, sont déposées deux couches de diélectriques et deux couches de polymères conducteurs.

L'invention concerne cependant d'autres modes de réalisation, par exemple le mode de réalisation où est déposée une seule couche diélectrique et une seule couche conductrice mais aussi les modes de réalisation où sont déposées plus de deux couches de diélectriques et plus de deux couches de polymères conducteurs. Les couches de diélectriques, de même que les couches de polymères conducteurs, peuvent alors être de nature différente. Il suffit pour cela de multiplier les cavités de dépôt selon les dépôts souhaités.

La figure 3 est une vue de détail du schéma de principe de la figure 2.

Cette vue représente le dispositif d'injection 8. Un ensemble de tubes d'injection 22 est contenu dans une gaine 21, laquelle comprend une partie évasée 7 à son extrémité. Chaque tube d'injection 22 débouche sur un orifice 23 de la partie évasée de la gaine.

Comme cela a été mentionné précédemment, les dispositifs d'injection 8 sont utilisés aussi bien pour le dépôt de diélectriques que pour le dépôt de polymères conducteurs.

Ainsi, les tubes d'injection 22 qui sont reliés aux sources 10, 11, 12 véhiculent-ils les gaz nécessaires au dépôt des couches diélectriques. De même, les tubes d'injection 22 qui sont reliés à la source 13 véhiculent-ils le gaz nécessaire au dépôt des couches de polymères conducteurs.

La figure 3 représente le dispositif d'injection 8 selon le mode de réalisation préférentiel. De façon générale, le dispositif d'injection 8 peut être tout système connu de l'homme de l'art et permettant de répartir les gaz précurseurs du dépôt uniformément au-dessus de la surface où s'effectue le dépôt.

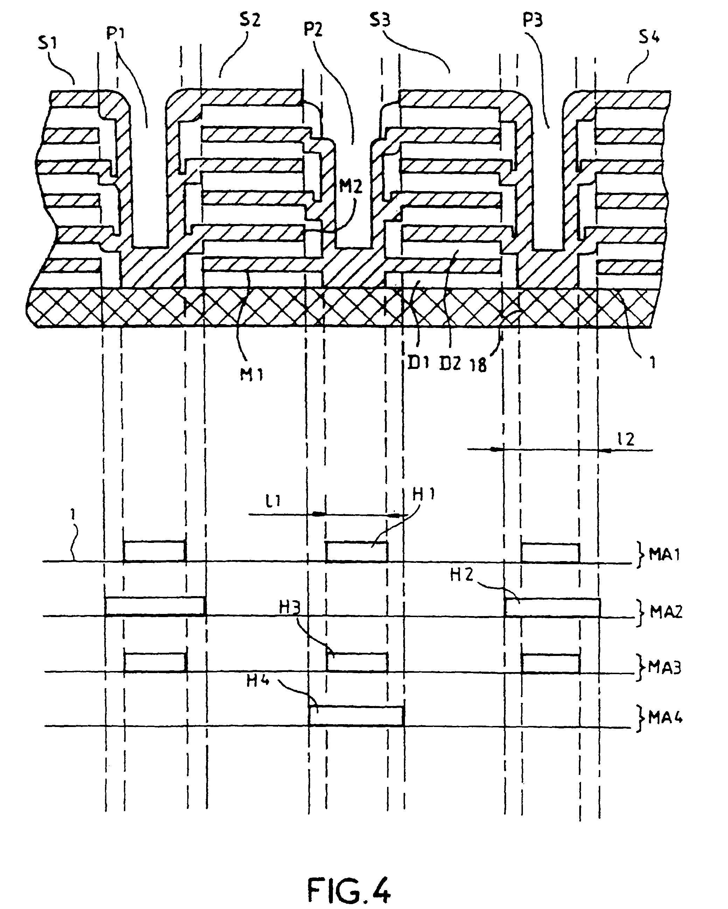

La figure 4 est une vue en coupe d'une structure capacitive obtenue selon le mode de réalisation préférentiel du procédé décrit en figure 2.

Sur la figure 4 sont aussi représentés de façon symbolique les masques MA1, MA2, MA3, MA4 associés aux dispositifs de masquage respectifs DM1, DM2, DM3, DM4.

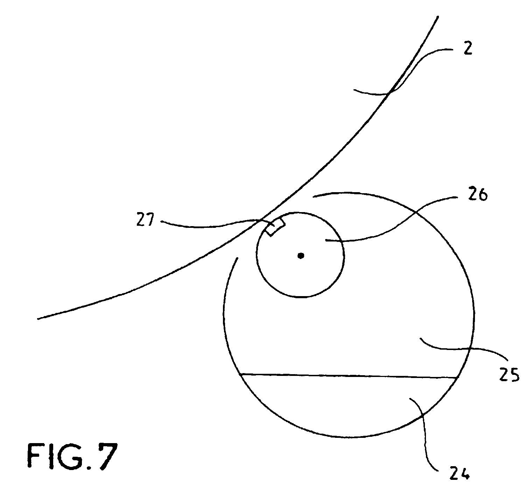

Préférentiellement, les différents masques MAi (i = 1, 2, 3, 4) sont réalisés par dépôt d'huile sur les zones où les dépôts de diélectrique et de polymère conducteur ne sont pas autorisés. Les dispositifs permettant de réaliser ces masques seront décrits en figure 7.

Le masque MA1 est réalisé par des dépôts d'huile H1 sur les zones à protéger du dépôt diélectrique. L'huile issue du dispositif de masquage DM1 se dépose le long de la surface 1 par suite de la rotation du tambour 2. Chaque dépôt d'huile H1 présente une largeur I1 dont la valeur est préférentiellement de l'ordre de 50 à 100 µm. Les dépôts d'huile H1 sont disposés parallèlement les uns aux autres et préférentiellement équidistants. Leur distance peut être, par exemple de l'ordre de 1 à 2 mm.

Le masque MA2 est réalisé par des dépôts d'huile H2 sur les zones à protéger du dépôt de polymère conducteur. L'huile issue du dispositif DM2 se dépose selon le même principe que celui décrit ci-dessus. La largeur I2 des dépôts d'huile H2 est plus grande que la largeur I1 précédente. Préférentiellement, la largeur I2 est supérieure de 20 à 30 % à la largeur I2. Les dépôts d'huile H1 et H2 sont effectués selon des axes parallèles. Ainsi les dépôts H2 sont-ils disposés de façon que chacun des axes défini par un dépôt H2 se juxtapose à un axe défini par un dépôt H1, la distance séparant les axes définis par deux dépôts H2 voisins étant le double de celle séparant les axes définis par deux dépôts H1 voisins.

Le masque MA3 est réalisé par des dépôts d'huile H3. Ce troisième masque MA3 est identique au premier masque MA1. Les dépôts d'huile H3 sont identiques en largeur et en position aux dépôts d'huile H1.

Le masque MA4 est réalisé par des dépôts d'huile H4. Chaque dépôt H4 est de largeur identique à la largeur des dépôts H2. Deux dépôts H4 voisins sont séparés de la même distance que deux dépôts H2 voisins. Cependant, l'axe que définit un dépôt H4 ne se superpose pas avec l'axe que définit un dépôt H2, mais se situe à équidistance entre les axes définis par deux dépôts H2 voisins.

Comme cela a été mentionné précédemment la constitution de la structure capacitive selon le mode de réalisation préférentiel de l'invention résulte du dépôt, à chaque révolution du tambour 2, de deux couches de diélectrique et de deux couches de polymère conducteur. La structure capacitive de la figure 4 comprend, pour des raisons de commodité de représentation, six couches diélectriques et six couches conductrices. Ainsi cette structure correspond-elle à trois révolutions du tambour 2. De façon plus générale, le nombre de révolutions du tambour 2 peut-être beaucoup plus grand et le nombre de couches peut atteindre plusieurs milliers.

La structure capacitive selon l'invention se présente sous forme d'un ensemble de N structures capacitives élémentaires Si (i = 1, 2, ..., N) en parallèle. Avantageusement, ces structures sont séparées les unes des autres par des puits Pi (i = 1,2, ..., N-1). Ces puits sont autant de zones permettant de faciliter la découpe de la structure capacitive en structures capacitives élémentaires.

La découpe peut alors être effectuée par tout moyen connu de l'homme de l'art. Avantageusement, selon un mode de réalisation de l'invention, elle peut aussi être effectuée par un système de découpe compatible des dispositifs de masquage, comme cela sera précisé ultérieurement (cf. fig. 7)

Selon l'invention, les parois latérales de chaque structure capacitive élémentaire sont conductrices. Il suffit alors soit de passer chaque structure capacitive élémentaire dans une vague d'alliage en fusion, soit de déposer un alliage de brasage ou crème à braser sur les parois latérales de chaque structure capacitive élémentaire afin de réaliser les armatures des futurs condensateurs. L'opération de shoopage qui était nécessaire, selon l'art antérieur, pour la fabrication des condensateurs à feuilles de films plastiques métallisés n'est plus nécessaire selon le procédé de l'invention.

Plus généralement, le procédé de l'invention réduit avantageusement le nombre d'étapes successives permettant de réaliser des condensateurs de type empilé.

Une fois les armatures réalisées, le procédé selon une modfification de l'invention comprend une étape de découpe des structures capacitives élémentaires afin de réaliser des condensateurs élémentaires.

Avantageusement les condensateurs ainsi réalisés sont des composants de volumes très faibles dont la capacité volumique peut atteindre, par exemple, 20 000 nF par mm³.

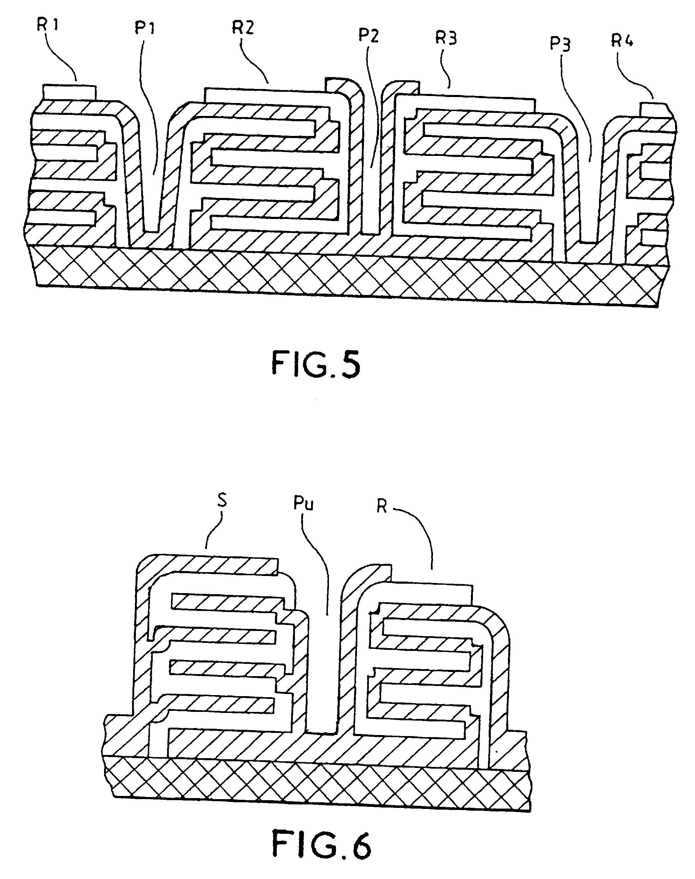

La figure 5 représente la vue en coupe d'une structure résistive obtenue selon l'invention.

Comme cela a été mentionné précédemment, l'invention concerne généralement un procédé permettant de déposer sur un substrat en rotation une succession de couches diélectriques et de couches de polymères conducteurs.

Ainsi l'invention concerne-t-elle un procédé de fabrication permettant la réalisation d'une structure résistive telle que celle représentée en figure 5. De même que la structure capacitive décrite ci-dessus, la structure résistive selon l'invention se présente sous la forme d'un ensemble de N structures résistives élémentaires Ri (i = 1, 2, ... , N) en parallèle, séparées les unes des autres par des puits Pi (i = 1, 2, ..., N-1). Chaque structure résistive élémentaire Ri a ses parois latérales métallisées. La succession des masques utilisés pour définir une telle structure est alors ajustée de façon que les parois latérales d'une même structure résistive élémentaire soient électriquement reliées entre elles et que les parois latérales de deux structures élémentaires voisines soient reliées entre elles par au moins un dépôt de polymère conducteur.

De même que pour les condensateurs décrits précédemment, les puits Pi sont autant de zones permettant de faciliter la découpe de la structure résistive en structures resistives élémentaires.

Le procédé selon une modification de l'invention comprend alors une étape de découpe des structures résistives élémentaires en résistances élémentaires.

Selon l'invention, les parois latérales de chaque structure résistive élémentaire sont conductrices. Il suffit alors soit de passer chaque structure résistive élémentaire dans une vague d'alliage en fusion, soit de déposer un alliage de brasage ou crème à braser sur les parois latérales de chaque structure résistive élémentaire afin de réaliser les connexions des futures résistances.

La figure 6 représente la vue en coupe d'une structure résistive et capacitive obtenue selon l'invention. Pour des raisons de commodité, seule une structure résistive élémentaire R et une structure capacitive élémentaire S ont été représentées. L'invention concerne cependant des structures composées de plusieurs structures capacitives élémentaires et de plusieurs structures résistives élémentaires. La structure capacitive élémentaire S est séparée de la structure résistive élémentaire R par un puits Pu.

La figure 7 est une vue en coupe d'un dispositif de masquage utilisé selon l'invention.

Une enceinte 25 contient de l'huile en phase liquide 24. Des éléments chauffants (non représentés sur la figure) permettent à l'huile de s'évaporer partiellement. L'huile en phase vapeur remplit les encoches 27 du rouleau d'impression 26 solidaire de l'enceinte 25. La largeur des encoches 27 définit la largeur des zones de masquage telles que I1 et I2 définies précédemment. La distance entre deux encoches voisines définit la distance entre les axes de deux zones de masquage voisines. Le rouleau d'impression est fixe. Le dépôt d'huile s'effectue sur le substrat qui tourne à la vitesse angulaire Ω du tambour 2. Ce dépôt est dû à la condensation de l'huile sur le substrat dont la température est plus basse que la température de l'huile.

Afin d'assurer des conditions optimales au dépôt d'huile sur le substrat, la distance séparant le rouleau d'impression 26 du substrat est maintenue quasiment constante, par exemple de l'ordre de quelques microns, lors de l'ensemble du procédé. La quantité d'huile transférée est contrôlée en ajustant la puissance de chauffe des éléments chauffants.

De façon générale, tous les types de motifs sont envisageables pour réaliser les encoches qui définissent un même masque.

Préférentiellement, les encoches 27 qui définissent un même masque sont alignées sur une même génératrice du rouleau d'impression 26. Il est alors possible de définir les motifs de masquage de différents masques sur le même rouleau d'impression. Les motifs de masquage à mettre en regard du substrat sont alors choisis par simple rotation du rouleau d'impression.

De même, les encoches 27 qui définissent un même masque peuvent être ajustées de façon qu'une structure réalisée selon le procédé de l'invention soit constituée d'une succession de structures élémentaires alternativement capacitives et résistives. Avantageusement, la découpe ultérieure d'une telle structure peut alors conduire à fabriquer des composants constitués d'une résistance et d'une capacité en série.

Les connexions de tels composants sont réalisées de la même manière que celle décrite ci-dessus pour les capacités ou les résistances.

Avantageusement, le rouleau d'impression 26 peut aussi servir de support à différents éléments coupants de façon à permettre la découpe de la structure capacitive et/ou de la structure résistive en structures élémentaires.

Selon le procédé préféré de l'invention, le rouleau 26 peut aussi permettre le marquage de différents logos sur les composants.

Selon l'art antérieur, les dépôts assistés par plasma de décharge sont effectués sur des substrats chauffés. Un avantage du dépôt par plasma froid différé en écoulement utilisé selon une modification de l'invention est de ne pas devoir chauffer le substrat sur lequel sont effectués les dépôts de diélectrique et de conducteur. Les caractéristiques mécaniques du substrat ne sont donc pas dégradées et la fiabilité des composants issus du procédé de cette modification de l'invention se trouve améliorée par rapport à celle des composants issus des procédés de l'art antérieur.

## Revendications

1. Procédé de fabrication d'un composant capacitif ou résistif, de type empilé, constitué d'un empilement de plusieurs couches diélectriques alternées avec plusieurs couches conductrices, les couches conductrices comportant successivement des couches de rang impair alternées avec des couches de rang pair, caractérisé en ce que les couches diélectriques et les couches conductrices sont réalisées respectivement par dépôt de matériau diélectrique en couche mince et par dépôt de matériau conducteur en couche mince.

2. Procédé de fabrication selon la revendication 1, caractérisé en ce que les dépôts conducteurs sont faits de manière à venir en contact d'un seul côté avec une couche conductrice précédemment déposée, et en ce que des empilements juxtaposés en parallèle Si ou Ri, avec i= 1,2, ..., N, séparés par des puits Pi, avec i = 1,2, ..., N-1, sont réalisés sur un substrat, chaque empilement présentant deux faces latérales opposées tournées vers les puits, ces faces se recouvrant de matériau conducteur au fur et à mesure des étapes successives de dépôt conducteur effectuées pour réaliser l'empilement.

3. Procédé de fabrication selon la revendication 2, caractérisé en ce que les dépôts conducteurs successifs des couches de rang pair viennent en contact direct à une extrémité des couches avec les dépôts conducteurs de rang pair précédemment déposées, et les couches de rang impair viennent en contact direct, à une autre extrémité des couches, avec les couches de rang impair précédemment déposées, pour réaliser un condensateur empilé.

4. Procédé de fabrication selon la revendication 2, caractérisé en ce qu'un dépôt conducteur de rang pair vient en contact direct, à une de ses extrémités, avec le dépôt de rang impair qui le précède immédiatement, et en ce que le dépôt conducteur de rang impair qui le suit immédiatement vient en contact direct a l'autre extrémité avec le dépôt de rang pair, pour réaliser une résistance empilée

5. Procédé de fabrication selon l'une des revendications 3 et 4, caractérisé en ce qu'on réalise sur un même substrat à la fois un condensateur et une résistance en série ou en parallèle avec ce condensateur

6. Procède selon l'une quelconque des revendications précédentes, caractérisé en ce que le dépôt d'eu moins une couche conductrice a lieu simultanément avez le dépôt d'au moins une couche diélectrique.

7. Procédé selon l'une quelconque des revendications précédentes, caractérisé en ce que le dépôt de couches minces diélectriques est réalisé par la polymérisation d'éléments issus de la dissociation par plasma différé d'azote d'un gaz organo-silicé ou organo-germané et en ce que le dépôt de couches minces conductrices est réalisé par dépôt d'éléments conducteurs issus de la dissocation par plasma différé d'azote d'un gaz précurseur de ces éléments.

8. Procédé selon la revendication 7, caractérisé en ce que ledit plasma différé d'azote est un plasma froid différé en écoulement situé dans une zone de post-décharge étendue ne contenant pratiquement pas d'électrons ou d'ions.

9. Procédé selon l'une quelconque des revendications 7 ou 8, caractérisé en ce que le composé organo-silicé est choisi parmi les alkoxysilanes de formule : 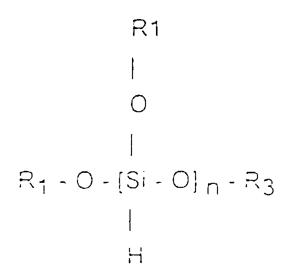 avec n inférieur ou égal à 5
les siloxanes de formule 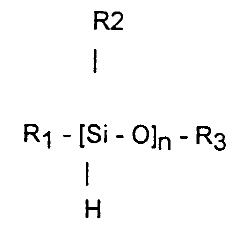 avec n inférieur ou égal à 4
ou les silazanes de formule 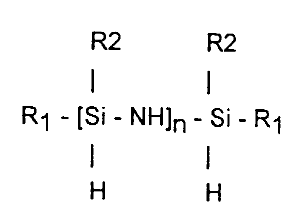 avec n inférieur à 4

10. Procédé selon la revendication 9, caractérisé en ce que le composé organo-silicé est du tétraméthyldisiloxane.

11. Procédé selon l'une quelconque des revendications 7 à 10, caractérisé en ce que le gaz précurseur des éléments conducteurs est un complexe métallique.

12. Procédé selon la revendication 11, caractérisé en ce que le complexe métallique est un métal carbonyle.

13. Procédé selon la revendication 11, caractérisé en ce que le complexe métallique est un acétyle acétonate ou un fluoro-acétyle acétonate.

14. Procédé selon l'une quelconque des revendications 7 à 10, caractérisé en ce que le gaz précurseur des éléments conducteurs est de l'hydrogène sulfureux.

15. Procédé selon l'un quelconque des revendications 7 à 10, caractérisé en ce que le gaz précurseur des éléments conducteurs est du dichlorure de soufre.

16. Procédé selon l'une quelconque des revendications 7 à 15, caractérisé en ce que la pression de l'azote est comprise entre 1 hPa et 20 hPa.

17. Procédé selon l'une quelconque des revendications 7 à 16, caractérisé en ce qu'il comprend la présence d'oxygène lors du dépôt des couches diélectriques.

18. Procédé selon l'une quelconque des revendications 6 à 17, caractérisé en ce que le dépôt des couches diélectriques et des couches conductrices s'effectue sur un substrat diélectrique (1) placé à la surface d'un tambour (2) en rotation, ladite rotation s'effectuant de façon qu'une même portion du substrat diélectrique (1) se trouve successivement en regard d'au moins un dispositif (C1, 8, 7) de dépôt de diélectrique et d'au moins un dispositif (C2, 8, 7) de dépôt d'éléments conducteurs, chaque dépôt de diélectrique ou de conducteur étant précédé d'un masquage des zones où ledit dépôt n'est pas autorisé.

19. Procédé selon la revendication 18, caractérisé en ce que ledit masquage est réalisé par dépôt d'huile.

20. Procédé selon la revendication 19, caractérisé en ce que ledit dépôt d'huile est réalisé par un dispositif de masquage constitué d'un rouleau d'impression sur lequel sont formées des encoches, lesdites encoches s'emplissant d'huile en phase vapeur, ladite huile en phase vapeur se déposant par condensation.

21. Procédé selon la revendication 20, caractérisé en ce que le masquage des zones où les dépôts de diélectrique et de polymère conducteur ne sont pas autorisés conduit à la fabrication d'une structure capacitive constituée de N structures capacitives élémentaires (Si, 1 = 1, 2, ... N) en parallèle séparées les unes des autres par des puits (Pi, 1 = 1, 2, ..., N-1), chaque structure capacitive élémentaire ayant ses parois latérales conductrices.

22. Procédé selon la revendication 21, caractérisé en ce qu'il comprend une étape de découpe de ladite structure capacitive en lesdites N structures capacitives élémentaires, ladite découpe étant réalisée par des éléments coupants solidaires du rouleau d'impression.

23. Procédé selon la revendication 22, caractérisé en ce que chaque structure capacitive élémentaire issue de ladite découpe est passée dans une vague d'alliage en fusion afin de constituer les armatures des futurs condensateurs.

24. Procédé selon la revendication 22, caractérisé en ce qu'il comprend le dépôt d'un alliage à braser sur les parois latérales de chaque structure capacitive élémentaire issue de ladite découpe afin de constituer les armatures des futurs condensateurs.

25. Procédé selon l'une quelconque des revendications 23 ou 24, caractérisé en ce qu'il comprend la découpe des structures capacitives élémentaires en condensateurs élémentaires.

26. Procédé selon la revendication 20, caractérisé en ce que le masquage des zones où les dépôts de diélectrique et de polymère conducteur ne sont pas autorisés conduit à la fabrication d'une structure résistive constituée de N structures résistives élémentaires (Ri, 1 = 1, 2, ..., N) séparées les unes des autres par des puits (Pi, 1 = 1, 2, N - 1), chaque structure résistive élémentaire ayant ses parois latérales conductrices et électriquement reliées entre elles.

27. Procédé selon la revendication 26, caractérisé en ce qu'il comprend une étape de découpe de ladite structure résistive en lesdites N structures résistives élémentaires, ladite découpe étant réalisée par des éléments coupants solidaires du rouleau d'impression.

28. Procédé selon la revendication 27, caractérisé en ce que chaque structure résistive élémentaire (Ri, 1 = 1, 2, ..., N) issue de ladite découpe est passée dans une vague d'alliage en fusion afin de constituer les connexions des futures résistances.

29. Procédé selon la revendication 27, caractérisé en ce qu'il comprend le dépôt d'un alliage à braser sur les parois latérales de chaque structure élémentaire issue de ladite découpe afin de constituer les bornes des futures résistances.

30. Procédé selon la revendication 28 ou 29, caractérisé en ce qu'il comprend la découpe de chaque structure résistive élémentaire en résistances élémentaires.

31. Procédé selon la revendication 20, caractérisé en ce que le masquage des zones où les dépôts de diélectrique et de polymère conducteur ne sont pas autorisés conduit à la fabrication d'une structure constituée d'une succession de structures élémentaires capacitives et résistives, chaque structure élémentaire capacitive et résistive ayant ses parois latérales conductrices, chaque structure élémentaire résistive ayant ses parois latérales électriquement reliées entre elles.

32. Procédé selon la revendication 31, caractérisé en ce qu'il comprend une étape de découpe de ladite structure en structures élémentaires constituées chacune d'une structure élémentaire capacitive et d'une structure élémentaire résistive.

33. Procédé selon la revendication 32, caractérisé en ce que chaque structure élémentaire est passée dans une vague d'alliage en fusion afin de constituer les connexions des futurs composants.

34. Procédé selon la revendication 33, caractérisé en ce qu'il comprend le dépôt d'un alliage à braser sur les parois latérales desdites structures élémentaires.

35. Procédé selon la revendication 34, caractérisé en ce qu'il comprend la découpe des structures élémentaires de façon à constituer des composants formés d'une capacité et d'une résistance en série.

36. Condensateur de type empilé constitué d'une alternance de couches diélectriques de rang impair et pair et de couches conductrices de rang impair et pair, ledit condensateur empilé constituant une structure ayant deux faces latérales opposées recouvertes de matériau conducteur, caractérisé en ce que les couches diélectriques sont obtenues par dépôts d'éléments diélectriques en couche mince et les couches conductrices par dépôts d'éléments conducteurs en couche mince, le recouvrement de matériau conducteur d'une première face latérale étant obtenu par lesdits dépôts d'éléments conducteurs de façon à relier électriquement entre elles les couches conductrices de rang pair et le recouvrement de matériau conducteur de la face latérale opposée à ladite première face étant obtenu par lesdits dépôts d'éléments conducteurs de façon à relier électriquement entre elle les couches conductrices de rang impair.

37. Résistance caractérisée en ce qu'elle est constituée d'une alternance de couches diélectriques de rang impair et pair et de couches conductrices de rang impair et pair, ladite alternance constituant une structure ayant deux faces latérales opposées recouvertes de matériau conducteur, les couches diélectriques étant obtenues par dépôts d'éléments diélectriques en couche mince et les couches conductrices par dépôt d'éléments conducteurs en couche mince, chaque couche conductrice ayant une première extrémité située sur une première face latérale et une deuxième extrémité située sur une deuxième face latérale opposée à la première face latérale, une couche conductrice de rang impair ayant sa première extrémité électriquement reliée à la première extrémité de la couche conductrice de rang pair immédiatement au-dessus et une couche conductrice de rang pair ayant sa deuxième extrémité électriquement reliée à la deuxième extrémité de la couche conductrice de rang impair immédiatement au-dessus, les liaisons électriques entre lesdites extrémités étant réalisées lors du dépôt des couches conductrices.

38. Composant électronique, caractérisé en ce qu'il est constitué d'au moins un condensateur selon la revendication 36 et d'au moins une résistance selon la revendication 37.

## Patentansprüche

1. Verfahren zur Herstellung eines kapazitiven oder resistiven Bauelements des Schichttyps, das aus einem Stapel aus mehreren dielektrischen Schichten, die mit mehreren leitenden Schichten abwechseln, gebildet ist, wobei die leitenden Schichten nacheinander Schichten mit ungerader Ordnungszahl, die mit Schichten mit gerader ordnungszahl abwechseln, enthalten, dadurch gekennzeichnet, daß die dielektrischen Schichten und die leitenden Schichten jeweils durch Abscheidung eines dielektrischen Materials als Dünnschicht bzw. durch Abscheidung eines leitenden Materials als Dünnschicht verwirklicht sind.

2. Herstellungsverfahren nach Anspruch 1, dadurch gekennzeichnet, daß die leitenden Abscheidungen in der Weise gebildet werden, daß sie von einer einzigen Seite mit einer vorher abgeschiedenen leitenden Schicht in Kontakt gelangen, und daß parallel nebeneinanderliegende Stapel Si oder Ri, mit 1 = 1, 2, ... N, die durch Schächte Pi, mit 1 = 1, 2, ..., N - 1, getrennt sind, auf einem Substrat verwirklicht werden, wobei jeder Stapel zwei gegenüberliegende und zu den Schächten gewendete Seitenflächen aufweist, die nach Maßgabe der folgenden Schritte der Leiterabscheidung, die für die Verwirklichung des Stapels ausgeführt werden, mit leitendem Material bedeckt werden.

3. Herstellungsverfahren nach Anspruch 2, dadurch gekennzeichnet, daß die aufeinanderfolgenden Leiterabscheidungen der Schichten mit geradzahliger Ordnungszahl an einem Ende der Schichten mit vorher aufgebrachten Leiterabscheidungen mit geradzahliger Ordnungszahl in direkten Kontakt gelangen und die Schichten mit ungerader Ordnungszahl an einem anderen Ende der Schichten mit den vorher aufgebrachten Schichten mit ungerader Ordnungszahl in direkten Kontakt gelangen, um einen Schichtkondensator herzustellen.

4. Herstellungsverfahren nach Anspruch 2, dadurch gekennzeichnet, daß eine Leiterabscheidung mit gerader Ordnungszahl an einem seiner Enden mit der ihm unmittelbar vorhergehenden Abscheidung mit ungerader Ordnungszahl in direkten Kontakt gelangt und daß die Leiterabscheidung mit ungerader Ordnungszahl, der ihm unmittelbar folgt, am anderen Ende mit der Abscheidung mit gerader Ordnungszahl in direkten Kontakt gelangt, um einen Schichtwiderstand herzustellen.

5. Herstellungsverfahren nach einem der Ansprüche 3 und 4, dadurch gekennzeichnet, daß auf demselben Substrat zugleich ein Kondensator und ein mit diesem Kondensator in Serie geschalteter oder parallelgeschalteter Widerstand verwirklicht werden.

6. Verfahren nach einem der vorangehenden Ansprüche, dadurch gekennzeichnet, daß die Abscheidung wenigstens einer leitenden Schicht gleichzeitig mit der Abscheidung wenigstens einer dieleketrischen Schicht erfolgt.

7. Verfahren nach einem der vorangehenden Ansprüche, dadurch gekennzeichnet, daß die Abscheidung der dielektrischen Dünnschichten durch Polymerisation von Elementen verwirklicht wird, die von der Dissoziation durch verzögertes Stickstoffplasma aus einem Organosilicium- oder Organogermanium-Gas stammen, und daß die Abscheidung der leitenden Dünnschichten durch Abscheidung von leitenden Elementen verwirklicht wird, die von der Dissoziation durch verzögertes Stickstoffplasma eines Vorläufergases dieser Elemente stammen.

8. Verfahren nach Anspruch 7, dadurch gekennzeichnet, daß das verzögerte Stickstoffplasma ein fließendes verzögertes kaltes Plasma ist, das sich in einer erweiterten Nachleuchtzone befindet, die im wesentlichen keine Elektronen oder Ionen enthält.

9. Verfahren nach einem der Ansprüche 7 oder 8, dadurch gekennzeichnet, daß die Organosiliciumverbindung aus den Alkoxysilanen mit der Formel: 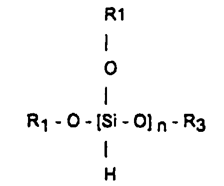 mit n kleiner oder gleich 5,
aus den Siloxanen mit der Formel 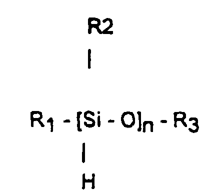 mit n kleiner oder gleich 4
oder aus den Silazanen mit der Formel 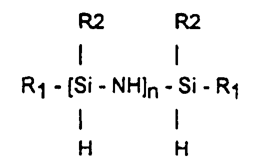 mit n kleiner als 4
gewählt ist.

10. Verfahren nach Anspruch 9, dadurch gekennzeichnet, daß die Organosiliciumverbindung Tetramethyldisiloxan ist.

11. Verfahren nach einem der Ansprüche 7 bis 10, dadurch gekennzeichnet, daß das Vorläufergas der leitenden Elemente ein Metallkomplex ist.

12. Verfahren nach Anspruch 11, dadurch gekennzeichnet, daß der Metallkomplex ein Carbonylmetall ist.

13. Verfahren nach Anspruch 11, dadurch gekennzeichnet, daß der Metallkomplex ein Acethyl-Acetonat oder ein Fluoracethyl-Acetonat ist.

14. Verfahren nach einem der Ansprüche 7 bis 10, dadurch gekennzeichnet, daß das Vorläufergas der leitenden Elemente Schwefelwasserstoff ist.

15. Verfahren nach einem der Ansprüche 7 bis 10, dadurch gekennzeichnet, daß das Vorläufergas der leitenden Elemente Schwefeldichlorid ist.

16. Verfahren nach einem der Ansprüche 7 bis 15, dadurch gekennzeichnet, daß der Druck des Stickstoffs im Bereich von 1 hPa bis 20 hPa liegt.

17. Verfahren nach einem der Ansprüche 7 bis 16, dadurch gekennzeichnet, daß bei der Abscheidung der dielektrischen Schichten Sauerstoff vorhanden ist.

18. Verfahren nach einem der Ansprüche 6 bis 17, dadurch gekennzeichnet, daß die Abscheidung der dielektrischen Schichten und der leitenden Schichten auf einem dielektrischen Substrat (1) erfolgt, das auf der Oberfläche einer sich drehenden Trommel (2) angeordnet ist, wobei die Drehung in der Weise erfolgt, daß derselbe Abschnitt des dielektrischen Substrats (1) sich nacheinander gegenüber wenigstens einer Vorrichtung (C1, 8, 7) für dielektrische Abscheidung und wenigstens einer Vorrichtung (C2, 8, 7) für die Abscheidung leitender Elemente befindet, wobei jeder dielektrischen oder leitenden Abscheidung eine Maskierung der Zonen vorhergeht, in denen die Abscheidung nicht zugelassen ist.

19. Verfahren nach Anspruch 18, dadurch gekennzeichnet, daß die Maskierung durch Ölabscheidung erfolgt.

20. Verfahren nach Anspruch 19, dadurch gekennzeichnet, daß die Ölabscheidung durch eine Maskierungsvorrichtung verwirklicht wird, die aus einer Druckwalze gebildet ist, auf der Vertiefungen gebildet sind, wobei sich die Vertiefungen mit Öl in der Dampfphase füllen, wobei das Öl in der Dampfphase durch Kondensation abgeschieden wird.

21. Verfahren nach Anspruch 20, dadurch gekennzeichnet, daß die Maskierung der Zonen, in denen die dielektrischen Abscheidungen und die Abscheidungen eines Leiterpolymers nicht zugelassen sind, zur Herstellung einer kapazitiven Struktur führt, die aus N elementaren kapazitiven Strukturen (Si, i= 1, 2, ..., N) gebildet ist, die zueinander parallel sind und voneinander durch Schächte (Pi, 1 = 1, 2, ..., N - 1) getrennt sind, wobei jede elementare kapazitive Struktur ihre leitenden Seitenwände besitzt.

22. Verfahren nach Anspruch 21, dadurch gekennzeichnet, daß es einen Schritt des Zerschneidens der kapazitiven Struktur in N elementare kapazitive Strukturen umfaßt, wobei das Zerschneiden durch Schneidelemente ausgeführt wird, die mit der Druckwalze fest verbunden sind.

23. Verfahren nach Anspruch 22, dadurch gekennzeichnet, daß jede elementare kapazitive Struktur, die sich aus dem Zerschneiden ergibt, in eine geschmolzene Legierungswelle geschickt wird, um die Belegungen künftiger Kondensatoren zu bilden.

24. Verfahren nach Anspruch 22, dadurch gekennzeichnet, daß es die Abscheidung einer Lötlegierung auf die Seitenwände jeder elementaren kapazitiven Struktur, die sich aus dem Zerschneiden ergibt, umfaßt, um die Belegungen künftiger Kondensatoren zu bilden.

25. Verfahren nach einem der Ansprüche 23 oder 24, dadurch gekennzeichnet, daß es das Zerschneiden der elementaren kapazitiven Strukturen in elementare Kondensatoren enthält.

26. Verfahren nach Anspruch 20, dadurch gekennzeichnet, daß die Maskierung der Zonen, in denen die dielektrischen Abscheidungen und die Abscheidungen des Leiterpolymers nicht zugelassen sind, zur Herstellung einer resistiven Struktur führt, die aus N elementaren resistiven Strukturen (Ri, i = 1, 2, ..., N) gebildet ist, die voneinander durch Schächte (Pi, 1 = 1, 2, ..., N - 1) getrennt sind, wobei jede elementare resistive Struktur ihre leitenden Seitenwände besitzt, die miteinander elektrisch verbunden sind.

27. Verfahren nach Anspruch 26, dadurch gekennzeichnet, daß es einen Schritt des Zerschneidens der resistiven Struktur in die N elementaren resistiven Strukturen enthält, wobei das Zerschneiden durch Schneidelemente ausgeführt wird, die mit der Druckwalze fest verbunden sind.

28. Verfahren nach Anspruch 27, dadurch gekennzeichnet, daß jede elementare resistive Struktur (Ri, i = 1, 2, ..., N), die sich durch das Zerschneiden ergibt, in eine geschmolzene Legierungswelle geschickt wird, um die Verbindungen künftiger Widerstände zu bilden.

29. Verfahren nach Anspruch 27, dadurch gekennzeichnet, daß es den Abscheidung einer Lötlegierung auf den Seitenwänden jeder aus dem Zerschneiden sich ergebenden elementaren Struktur enthält, um die Anschlüsse künftiger Widerstände zu bilden.

30. Verfahren nach Anspruch 28 oder 29, dadurch gekennzeichnet, daß es das Zerschneiden jeder elementaren resistiven Struktur in elementare Widerstände enthält.

31. Verfahren nach Anspruch 20, dadurch gekennzeichnet, daß die Maskierung der Zonen, in denen die dielektrischen Abscheidungen und die Abscheidungen des leitenden Polymers nicht zugelassen sind, zur Herstellung einer Struktur führt, die aus einer Folge von elementaren kapazitiven und resistiven Strukturen gebildet ist, wobei jede kapazitive und resistive elementare Struktur ihre leitenden Seitenwände besitzt und wobei für jede resistive elementare Struktur ihre Seitenwände miteinander elektrisch verbunden sind.

32. Verfahren nach Anspruch 31, dadurch gekennzeichnet, daß es einen Schritt des Zerschneidens der Struktur in elementare Strukturen enthält, die jeweils aus einer kapazitiven elementaren Struktur und einer resistiven elementaren Struktur gebildet sind.

33. Verfahren nach Anspruch 32, dadurch gekennzeichnet, daß jede elementare Struktur in eine geschmolzene Legierungswelle geschickt wird, um die Verbindungen künftiger Bauelemente zu bilden.

34. Verfahren nach Anspruch 33, dadurch gekennzeichnet, daß es die Abscheidung einer Lötlegierung auf den Seitenwänden der elementaren Strukturen enthält.

35. Verfahren nach Anspruch 34, dadurch gekennzeichnet, daß es das Zerschneiden der elementaren Strukturen in der Weise enthält, daß Bauelemente gebildet werden, die aus einer Serienschaltung einer Kapazität und eines Widerstandes gebildet sind.

36. Kondensator des Schichttyps, der aus einer abwechselnden Folge von dielektrischen Schichten mit ungerader und gerader Ordnungszahl und von leitenden Schichten mit ungerader und gerader Ordnungszahl gebildet ist, wobei der Schichtkondensator eine Struktur bildet, die zwei gegenüberliegende Seitenflächen besitzt, die mit dem Leitermaterial beschichtet sind, dadurch gekennzeichnet, daß die dielektrischen Schichten durch Abscheidungen dielektrischer Elemente als Dünnschicht erhalten werden und die leitenden Schichten durch Abscheidungen leitender Elemente als Dünnschicht erhalten werden, wobei die Beschichtung einer ersten Seitenfläche mit leitendem Material durch die Abscheidungen von leitenden Elementen erhalten wird, derart, daß die leitenden Schichten mit gerader Ordnungszahl elektrisch miteinander verbunden werden, und die Beschichtung der der ersten Fläche gegenüberliegenden Seitenfläche mit leitendem Material durch die Abscheidungen von leitenden Elementen erhalten wird, derart, daß die leitenden Schichten mit ungerader Ordnungszahl elektrisch miteinander verbunden werden.

37. Widerstand, dadurch gekennzeichnet, daß er aus einer abwechselnden Folge von dielektrischen Schichten mit ungerader und gerader Ordnungszahl und leitenden Schichten mit ungerader und gerader Ordnungszahl gebildet ist, wobei die abwechselnde Folge eine Struktur bildet, die zwei gegenüberliegende Seitenflächen besitzt, die mit leitendem Material beschichtet sind, wobei die dielektrischen Schichten durch Abscheidungen dielektrischer Elemente als Dünnschicht erhalten werden und die leitenden Schichten durch Abscheidung leitender Elemente als Dünnschicht erhalten werden, wobei jede leitende Schicht ein erstes Ende, das sich bei einer ersten Seitenfläche befindet, sowie ein zweites Ende besitzt, das sich bei einer zweiten Seitenfläche befindet, die der ersten Seitenfläche gegenüberliegt, wobei eine leitende Schicht mit ungerader Ordnungszahl mit ihrem ersten Ende mit dem ersten Ende der unmittelbar darüber befindlichen leitenden Schicht mit gerader Ordnungszahl elektrisch verbunden ist und eine leitende Schicht mit gerader Ordnungszahl mit ihrem zweiten Ende mit dem zweiten Ende der unmittelbar darüber befindlichen leitenden Schicht mit ungerader Ordnungszahl elektrisch verbunden ist, wobei die elektrischen Verbindungen zwischen den Enden bei der Abscheidung der leitenden Schichten verwirklicht werden.

38. Elektronisches Bauelement, dadurch gekennzeichnet, daß es aus wenigstens einem Kondensator nach Anspruch 36 und aus wenigstens einem Widerstand nach Anspruch 37 gebildet ist.

## Claims

1. Process for fabricating a capacitive or resistive component, of the stacked type, consisting of a stack of a plurality of dielectric layers alternated with a plurality of conductive layers, the conductive layers successively including layers of odd rank alternated with layers of even rank, characterized in that the dielectric layers and the conductive layers are respectively produced by thin-film deposition of dielectric material and by thin-film deposition of conducting material.

2. Fabrication process according to Claim 1, characterized in that the conducting deposits are made in such a way as to come into contact on one single side with a conductive layer previously deposited, and in that stacks juxtaposed in parallel Si or Ri, with i = 1,2, ...,N, separated by wells Pi, with i = 1,2,... ,N-1, are produced on a substrate, each stack having two opposite side faces turned towards the wells, these faces being covered with conducting material as the successive steps of conductor deposition performed in order to produce the stack proceed.

3. Fabrication process according to Claim 2, characterized in that the successive conducting deposits of the layers of even rank come into direct contact at one end of the layers with the conducting deposits of even rank previously deposited, and the layers of odd rank come into direct contact at another end of the layers, with the layers of odd rank previously deposited, in order to produce a stacked capacitor.

4. Fabrication process according to Claim 2, characterized in that a conducting deposit of even rank comes into direct contact, at one of its ends, with the deposit of odd rank which immediately precedes it, and in that the conducting deposit of odd rank which immediately follows it comes into direct contact at the other end with the deposit of even rank, in order to produce a stacked resistor.

5. Fabrication process according to one of Claims 3 and 4, characterized in that both a capacitor and a resistor, in series or in parallel with this capacitor, are produced on the same substrate.

6. Process according to any one of the preceding claims, characterized in that the deposition of at least one conductive layer takes place simultaneously with the deposition of at least one dielectric layer.

7. Process according to any one of the preceding claims, characterized in that the dielectric thin films are deposited by the polymerization of elements resulting from the remote nitrogen plasma dissociation of an organosilicon or organogermanium gas, and in that the deposition of the conductive thin films is carried out by depositing conducting elements resulting from the remote nitrogen plasma dissociation of a precursor gas of these elements.

8. Process according to Claim 7, characterized in that the said remote nitrogen plasma is a flowing remote cold plasma situated in an extended post-discharge zone containing practically no electrons or ions.

9. Process according to either one of Claims 7 or 8, characterized in that the organosilicon compound is chosen from alkoxysilanes of the formula: 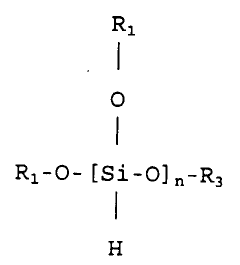 with n less than or equal to 5
siloxanes of formula 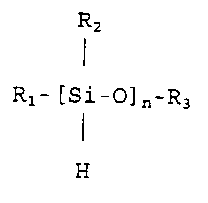 with n less than or equal to 4
or silazanes of formula 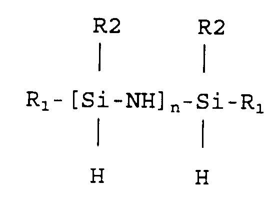 with n less than 4

10. Process according to Claim 9, characterized in that the organosilicon compound is tetramethyldisiloxane.

11. Process according to any one of Claims 7 to 10, characterized in that the precursor gas of the conducting elements is a metal complex.

12. Process according to Claim 11, characterized in that the metal complex is a metal carbonyl.

13. Process according to Claim 11, characterized in that the metal complex is an acetylacetonate or a fluoroacetylacetonate.

14. Process according to any one of Claims 7 to 10, characterized in that the precursor gas of the conducting elements is hydrogen sulphide.

15. Process according to any one of Claims 7 to 10, characterized in that the precursor gas of the conducting elements is sulphur dichloride.

16. Process according to any one of Claims 7 to 15, characterized in that the nitrogen pressure is between 1 hPa and 20 hPa.

17. Process according to any one of Claims 7 to 16, characterized in that it comprises the presence of oxygen during the deposition of the dielectric layers.

18. Process according to any one of Claims 6 to 17, characterized in that the deposition of the dielectric layers and of the conductive layers takes place on a dielectric substrate (1) placed on the surface of a rotating drum (2), the said rotation taking place in such a way that the same portion of the dielectric substrate (1) is located successively facing at least one device (C1, 8, 7) for dielectric deposition and at least one device (C2, 8, 7) for deposition of conducting elements, each dielectric or conductor deposition being preceded by masking of the zones where the said deposition is not allowed.

19. Process according to Claim 18, characterized in that the said masking is carried out by oil deposition.

20. Process according to Claim 19, characterized in that the said oil deposition is produced by a masking device consisting of a printing roller on which notches are formed, the said notches being filled with oil in vapour phase, the said oil in vapour phase being deposited by condensation.

21. Process according to Claim 20, characterized in that the masking of the zones where the depositions of dielectric and of conducting polymer are not allowed leads to the fabrication of a capacitive structure consisting of N elementary capacitive structures (Si, i = 1, 2, ... N) in parallel, separated from one another by wells (Pi, i = 1, 2, ..., N-1), each elementary capacitive structure having its side walls conductive.

22. Process according to Claim 21, characterized in that it comprises a step of cutting the said capacitive structure into the said N elementary capacitive structures, the said cutting being produced by cutting elements integral with the printing roller.

23. Process according to Claim 22, characterized in that each elementary capacitive structure resulting from the said cutting is passed through a molten alloy wave in order to form the plates of the future capacitors.

24. Process according to Claim 22, characterized in that it comprises the deposition of a soldering alloy on the side walls of each elementary capacitive structure resulting from the said cutting, in order to constitute the plates of the future capacitors.

25. Process according to either one of Claims 23 or 24, characterized in that it comprises the cutting of the elementary capacitive structures into elementary capacitors.

26. Process according to Claim 20, characterized in that the masking of the zones where the depositions of dielectric and of conducting polymer are not allowed leads to the fabrication of a resistive structure consisting of N elementary resistive structures (Ri, i = 1, 2, ..., N) which are separated from one another by wells (Pi, i = 1, 2, ... N - 1), each elementary resistive structure having its side walls conductive and electrically connected to one another.

27. Process according to Claim 26, characterized in that it comprises a step of cutting the said resistive structure into the said N elementary resistive structures, the said cutting being produced by cutting elements integral with the printing roller.

28. Process according to Claim 27, characterized in that each elementary resistive structure (Ri, i = 1, 2, ..., N) resulting from the said cutting is passed through a molten alloy wave in order to form the connections of the future resistors.

29. Process according to Claim 27, characterized in that it comprises the deposition of a soldering alloy on the side walls of each elementary structure resulting from the said cutting, in order to constitute the terminals of the future resistors.

30. Process according to Claim 28 or 29, characterized in that it comprises the cutting of each elementary resistive structure into elementary resistors.

31. Process according to Claim 20, characterized in that the masking of the zones where the depositions of dielectric and of conducting polymer are not allowed leads to the fabrication of a structure consisting of a succession of capacitive and resistive elementary structures, each capacitive and resistive elementary structure having its side walls conductive, each resistive elementary structure having its side walls electrically connected to one another.

32. Process according to Claim 31, characterized in that it comprises a step of cutting the said structure into elementary structures each consisting of a capacitive elementary structure and a resistive elementary structure.

33. Process according to Claim 32, characterized in that each elementary structure is passed through a molten alloy wave in order to form the connections of the future components.

34. Process according to Claim 33, characterized in that it comprises the deposition of a soldering alloy on the side walls of the said elementary structures.

35. Process according to Claim 34, characterized in that it comprises the cutting of the elementary structures so as to constitute components formed by a capacitor and a resistor in series.

36. Capacitor of the stacked type, consisting of an alternation of dielectric layers of odd and even rank and of conductive layers of odd and even rank, the said stacked capacitor constituting a structure having two opposite side faces covered with conducting material, characterized in that the dielectric layers are obtained by thin-film deposits of dielectric elements and the conductive layers are obtained by thin-film deposits of conducting elements, the covering of a first side face with conducting material being obtained by the said deposits of conducting elements so as to connect together electrically the conductive layers of even rank, and the covering of the side face opposite the said first face with conducting material being obtained by the said deposits of conducting elements so as to connect together electrically the conductive layers of odd rank.

37. Resistor characterized in that it consists of an alternation of dielectric layers of odd and even rank and of conductive layers of odd and even rank, the said alternation constituting a structure having two opposite side faces covered with conducting material, the dielectric layers being obtained by thin-film deposits of dielectric elements and the conductive layers being obtained by thin-film deposit of conducting elements, each conductive layer having a first end located on a first side face and a second end located on a second side face, opposite the first side face, a conductive layer of odd rank having its first end electrically connected to the first end of the conductive layer of even rank immediately above, and a conductive layer of even rank having its second end electrically connected to the second end of the conductive layer of odd rank immediately above, the electrical connections between the said ends being produced during the deposition of the conductive layers.

38. Electronic component, characterized in that it consists of at least one capacitor according to Claim 36 and at least one resistor according to Claim 37.
